# EUROPEAN PATENT APPLICATION

(11) **EP 4 439 660 A1**
(43) Date of publication of application: **02.10.2024**
(21) Application number: 24164787.4
(22) Date of filing: 20.03.2024
(51) Int. Cl.: H01L 23/495, H01L 25/07

(54) **MULTI-LEVEL POWER MODULE WITH REDUCED PARASITIC EFFECTS**

(30) Priority: 30.03.2023 IT 202300006201
(71) Applicant: STMicroelectronics International N.V., 1228 Plan-les-Ouates, Geneva (CH)
(72) Inventor: SUTERA, Dario, 95027 SAN GREGORIO DI CATANIA (CT) (IT)
(74) Representative: Studio Torta S.p.A.

(57) **Abstract**

A power module (21) includes an insulating body (30) having a first main face (30a) and a second main face (30b); a first contact plate (27) and a second contact plate (28), respectively protruding through the first main face (30a) and through the second main face (30b) of the insulating body (30) and accessible from the outside of the power module (21); a first power plate (31) and a second power plate (33), at least partially embedded in the insulating body (30), facing each other and having plane faces perpendicular to a first direction (Z). Power devices (22) of a first group (21a) are accommodated on the first power plate (31) and coupled to the first contact plate (27). Power devices (22) of a second group (21b) are accommodated on the second power plate (33) and coupled to the second contact plate (28). The first contact plate (27), the second contact plate (28), the first power plate (31) and the second power plate (33), are stacked along the first direction (Z) .

## Description

### Technical Field

The present invention relates to a power module comprising semiconductor power devices arranged in a multilevel structure with reduced parasitic effects.

### Background

"Power electronics" generally refers to the branch of technology dedicated to the management of the electrical energy flow which studies solutions capable of providing a certain load, or user, with voltages and currents suitable for its supply. The so-called "power" modules are units that transform and/or influence the energy coming from one or more sources, in order to direct it to one or more loads. For example, the power modules commonly called "inverters" transform direct current (DC) into alternate current (AC), to supply an alternate current load; the power modules commonly referred to as "rectifiers" transform alternate current into direct current; or again, the power modules called "DC/DC converters" are capable of increasing or decreasing direct voltages (DC) between an input and an output.

There is currently a large variety of applications wherefor electrical power transformation and/or conditioning is required. Just to name a few, rectifier and DC/DC converter modules may be found in the charging units of consumer electronic devices or to operate machines that operate at low DC voltage. In the ever more prominent field of electric vehicles, and in general of the electric drive of means of transport, the energy coming from a battery storing it in the form of DC electric charge is inverted by modules which transform it into energy usable by AC loads. Similarly, in the field of energy from renewable sources, assemblies of photovoltaic modules naturally produce direct energy which is to be inverted to be exported and fed into the alternate distribution electrical grid.

The power modules may accommodate different power devices, made using semiconductor technology and implemented in suitable circuit solutions for the purposes of energy transformation. The semiconductor power devices, inside the modules, are typically soldered or sintered on a substrate which functions as a support for the same power devices, provides the necessary contacts and electrical insulations and ensures the essential thermal contact for maximizing the operating efficiency of the power module.

Power devices typically pertain to silicon (Si) or silicon carbide (SiC) technology, such as, for example, MOSFET ("Metal Oxide Semiconductor Field-Effect Transistor") transistors, superjunction MOSFETs, IGBTs ("Insulated-Gate Bipolar Transistor") and the like, capable of operating at high voltages (up to hundreds of Volts) and with currents having fast switching time trends, for example Gallium Nitride (GaN) devices.

One of the most widespread circuit configurations in the field of power modules is the so-called "bridge" configuration, and more specifically the "half-bridge" configuration, which is the basic element of high-power converters.

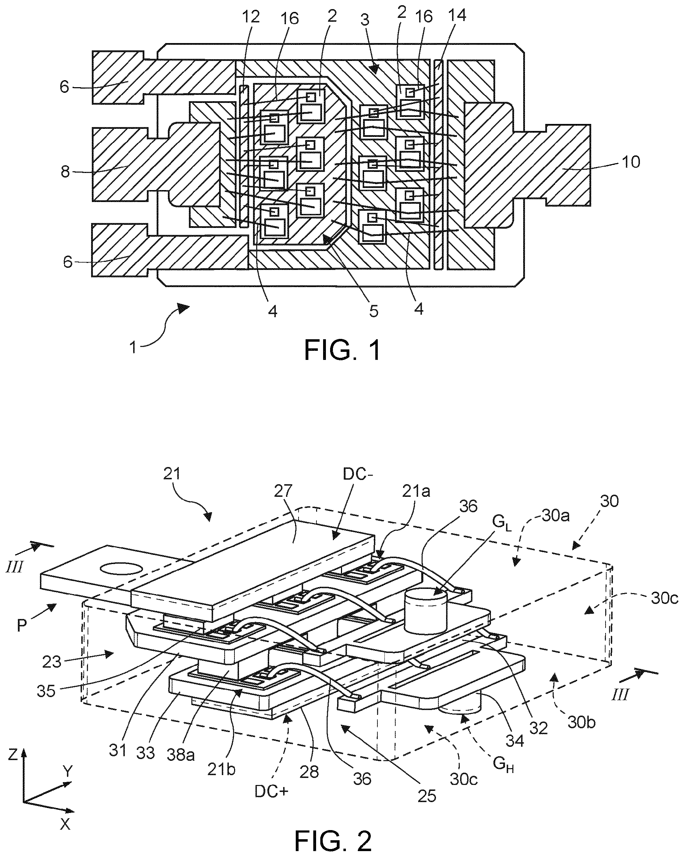

Figure 1 shows a power module 1, used for example as an inverter, which has a half-bridge configuration: this type of configuration generally provides for a first side 3 and a second side 5, also called, respectively, "high-side" and "low-side", comprising circuit elements such as power devices 2 of the type previously described; the power devices 2 may furthermore be vertical-channel transistors. Typically, the two sides 3, 5 have the source terminals of the power devices 2 of the high-side 3 electrically connected in series, by wires 4, with the drain terminals of the power devices 2 of the low-side 5, being able to define the two sides 3, 5 as cascade connected".

A first terminal 6 is connected externally to the power module 1 to the positive terminal of a DC power source (not represented in Figure 1) and internally to the drain terminals of the power devices 2 of the high-side 3. A second terminal 8 is connected externally to the negative terminal of the DC power source and internally to the source terminals of the power devices 2 of the low-side 5. A third terminal 10 is connected externally to a load which is to be supplied with alternate current (not represented in Figure 1) and internally to the source terminals of the power devices 2 of the high-side 3. The first and the second terminals 6, 8 represent the input terminals of the power module 1, while the third terminal 10 represents the output terminal of the power module 1. The gate terminals of the power devices 2 of the low-side 5 are connected through wires 16 to a fourth terminal 12; the gate terminals of the power devices 2 of the high-side 3 are connected through wires 16 to a fifth terminal 14. The fourth and the fifth terminals 12, 14 act as external control terminals for switching the two sides 3, 5 and are electrically connected to external terminals of the power module 1 in a manner not shown in Figure 1.

In modules currently available on the market, such as the power module 1 of Figure 1, the two sides 3, 5 typically lie on a same plane of the power module 1 and the electrical connection between the high-side 3 and the low-side 5 is made using wire bonding technology. The wires 4 may give rise to long current paths such as to generate high parasitic effects - mainly quantifiable in terms of parasitic resistances and inductances - which may limit the switching speed of the power module 1 and generate significant switching losses. The switching losses may negatively affect the operating efficiency of the power module 1, representing, in fact, energy in the form of heat which is to be evacuated from the power module 1 in order to ensure the desired performances.

### Summary

It is therefore an aim of the present invention to overcome or at least mitigate the disadvantages and limitations of the state of the art.

According to the present invention, there are provided a power module and a method for assembling a power module as defined in claims 1 and 16, respectively.

### Brief Description of the Figures

For a better understanding of the present invention, preferred embodiments are presented, by way of non-limiting example, with reference to the attached drawings, wherein:
- Figure 1 is a top-plan view of a power module according to the state of the art;
- Figure 2 is a perspective view of a power module in accordance with an embodiment of the present invention;
- Figure 3 is a cross-section through the power module of Figure 2, taken along line III-III of Figure 2;
- Figure 4 is an exploded perspective view of the power module of Figure 2;
- Figure 5 is an electric diagram relating to the power module of Figure 2;
- Figures 6-12 show successive steps of a process for assembling the power module of Figure 2;
- Figure 13 is a perspective view of a power module in accordance with a different embodiment of the present invention;
- Figure 14 is a cross-section through the power module of Figure 13, taken along line XIV-XIV of Figure 13;
- Figure 15 is a perspective view of a power module in accordance with a further embodiment of the present invention;
- Figure 16 is a cross-section through the power module of Figure 15, taken along line XVI-XVI of Figure 15; and
- Figure 17 is a cross-section through the power module of Figure 15, taken along line XVII-XVII of Figure 15.

### Description of Embodiments

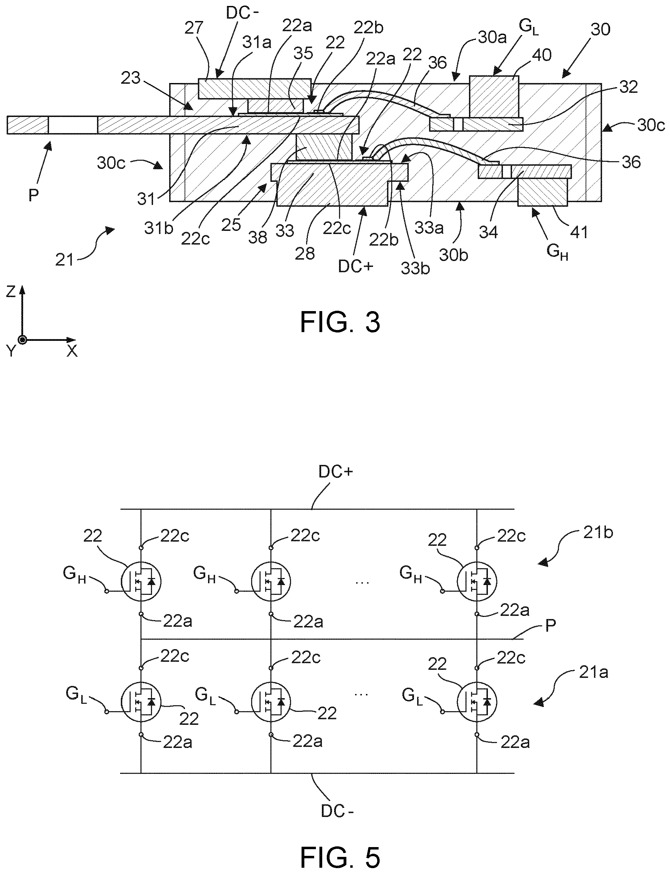

With reference to Figures 2-4, a power module in accordance with an embodiment of the present invention is indicated as a whole by the number 21 and comprises a plurality of power devices 22, a first connection structure or lead frame 23, accommodating a first group of power devices 22 which define a low-side 21a of the power module 21, a second connection structure or lead frame 25, accommodating a second group of power devices 22 which define a high-side 21b of the power module 21, a first contact plate 27 and a second contact plate 28. In this case, the terms "high" and "low" refer to the supply voltage, as usual in the sector. In particular, the high-side 21b is intended to be coupled to a power supply source at a higher voltage and the low-side 21a is intended to be coupled to a power supply source at a lower voltage. In the embodiment of Figures 2-4 the low-side 21a and the high-side 21b each comprise three power devices 22 arranged side by side to each other. However, it is understood that the number of power devices 22 in the high-side 21b and in the low-side 21a may be chosen based on the design preferences as suggested in the electric diagram of Figure 5, without significantly altering the structure of the power module 21.

The power module 21 further comprises an insulating body 30 of a resin or other polymeric material, wherein the first lead frame 23 and the second lead frame 25 are at least partially embedded. The insulating body 30 has a parallelepiped shape and has a first main face 30a and a second main face 30b opposite to each other and lateral faces 30c opposite in pairs. The first contact plate 27 and the second contact plate 28 protrude respectively through the first main face 30a and the second main face 30b of the insulating body 30 remaining exposed to be accessible from the outside and respectively define a low-side supply terminal (DC-) and a high-side supply terminal (DC+) of the power module 21.

The power devices 22 may be of any type, for example MOSFET ("Metal Oxide Semiconductor Field-Effect Transistor") transistors, superjunction MOSFETs, IGBTs ("Insulated-Gate Bipolar Transistor"), silicon carbide (SiC) or gallium nitride (GaN) devices and the like, capable of operating at high voltages (up to thousands of Volts, such as 1200 V SiC devices) and with currents having fast switching time trends (up to tens of Megahertz). In the embodiment of Figures 2-4, in particular, the power devices are vertical-channel power MOS transistors with source terminals 22a and gate terminals 22b on a first face and drain terminals 22c (Figure 3) on a second face.

The power devices 22 are also coupled to each other so as to form a power circuit, according to the design preferences. For example, in the embodiment of Figures 2-4 the power devices 22 are coupled so as to form a half-bridge circuit, as shown in the electric diagram of Figure 5. In particular, the power devices 22 of the high-side 21b are connected in parallel with each other and the power devices 22 of the low-side 21a are connected in parallel with each other. However, it is understood that the power devices 22 might be organized differently according to the function of the power module 21, for example in a bridge configuration.

The first lead frame 23 and the second lead frame 25 are of electrically and thermally conductive material, for example copper, are arranged on respective distinct levels inside the insulating body 30 and are partially superimposed. In more detail, the first lead frame 23 comprises a first power plate 31 and a first control plate 32; the second lead frame 25 comprises a second power plate 33 and a second control plate 34. The first power plate 31 and the second power plate 33 at least partly face each other. The first control plate 32 and the second control plate 34 at least partly face each other and are coplanar respectively with the first power plate 31 and the second power plate 33.

The first power plate 31 has a first face 31a and a second face 31b opposite to each other. Considering a reference system of orthogonal axes X, Y, Z, each of the first and second face 31a, 31b of the first power plate 31 is a plane face perpendicular to the Z axis. Furthermore, a portion of the first power plate 31 protrudes through one of the lateral faces 30c of the insulating body 30 and defines a phase terminal P of the power module 21. The first control plate 32 is aligned along the X axis with the first power plate 31.

The first face 31a of the first power plate 31 accommodates the power devices 22 of the low-side 21a and the second face 31b of the first power plate 31 is oriented towards the second power plate 33.

The second power plate 33 has a first face 33a and a second face 33b opposite to each other. Each of the first and second face 33a, 33b of the second power plate 33 is a plane face perpendicular to the Z axis. The first face 33a of the second power plate 33 is oriented towards the first power plate 31 and accommodates the power devices 22 of the high-side 21b. The power devices 22 of the high-side 21b are therefore interposed between the first power plate 31 and the second power plate 33. The second control plate 34 is aligned along the X axis with the second power plate 33.

The power devices 22 of the low-side 21a have the respective drain terminals 22c joined to the first face 31a of the first power plate 31 for example by sintering.

The source terminals 22a of the power devices 22 of the low-side 21a are coupled to the first contact plate 27 through respective conductive columns 35 for connection to the outside, in particular with a power supply source at a lower voltage. The first contact plate 27 and the conductive columns 35 may be formed in a single piece.

The gate terminals 22b of the power devices 22 of the low-side 21a are connected to the first control plate 32 by respective bonding wires 36.

The power devices 22 of the high-side 21b have the respective drain terminals 22c joined to the first face 33a of the second power plate 33 for example by sintering. In turn, the second power plate 33 is joined, for example formed in a single piece, to the second contact plate 28 for connection to the outside, in particular to a power supply source at a higher voltage.

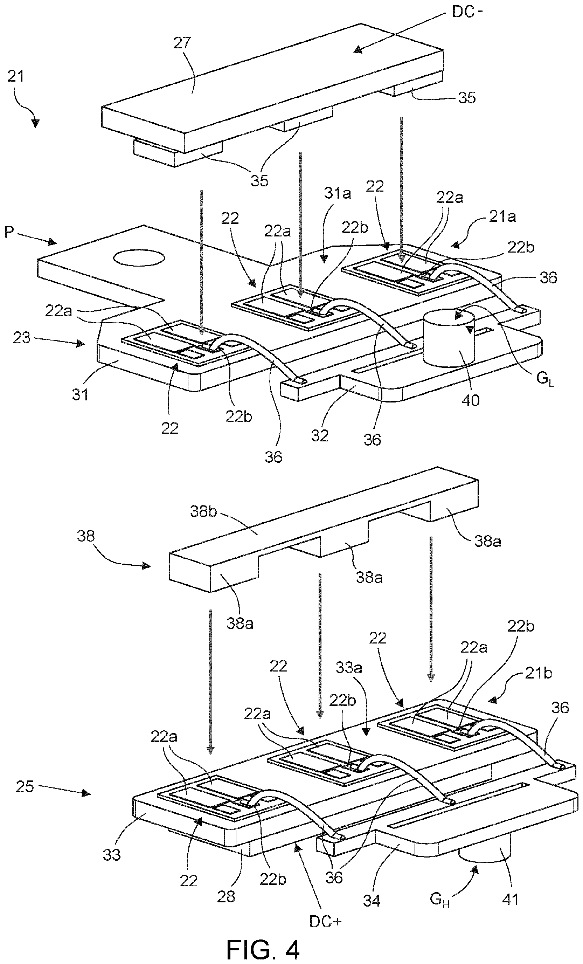

A conductive bridge 38 (see in particular Figure 4) couples the source terminals 22a of the power devices 22 of the high-side 21b to each other and to the first power plate 31. More precisely, the conductive bridge 38 has struts 38a joined to the source terminals 22a and a crosspiece 38b joined to the second face 31b of the first power plate 31. Alternatively, the struts may be fixed directly to the first power plate 31, which in this case also functions as a bridge to couple the source terminals 22a to each other.

The gate terminals 22b of the power devices 22 of the high-side 21b are connected to the second control plate 34 by respective bonding wires 36.

In practice, the first contact plate 27, the second contact plate 28, the first power plate 31, the second power plate 33, the power devices 22 of the low-side 21a and the high-side 21b are all at least partially superimposed and at least partly stacked along the Z axis. The conductive columns 35 and the conductive bridge 38 define conductive paths which extend perpendicular to the first power plate 31 and the second power plate 33 and therefore have minimum length. Consequently, the conductive paths between the high-side supply terminal (DC+) and the phase terminal P and between the low-side supply terminal (DC-) and the phase terminal P are also minimized.

In one embodiment, the first control plate 32 and the second control plate 34 are completely embedded in the insulating body 30 and are respectively provided with a first conductive pillar 40, which protrudes through the first main face 30a, and with a second conductive pillar 41, which protrudes through the second main face 30b. The protruding portions of the first conductive pillar 40 and of the second conductive pillar 41 respectively define a control terminal G_{L} of the low-side 21a and a control terminal G_{H} of the high-side 21b of the power module 21.

Furthermore, the first control plate 32 and the second control plate 34 are shaped so that the conductive paths respectively between the control terminal G_{L} and the gate terminals 22b of the power devices 22 of the low-side 21a and between the control terminal G_{H} and the gate terminals 22b of the power devices 22 of the high-side 21b are balanced as to the associated resistance, inductance and capacitance components.

Thanks to the stacked arrangement of the components of the power module 21, the conductive paths between the supply terminals DC+, DC- and the phase terminal P are extremely short and develop through components with a very wide passage section, without the need for intermediate bonding wires. The internal parasitic components associated with regions subject to the flow of high currents may be practically eliminated, to the benefit of the switching speed and the reduction of the associated losses.

In the embodiment described, the balancing of the electrical paths between the control terminals G_{L}, G_{H} and the gate terminals 22b of the power devices 22 allows the power devices 22 to be driven in a coherent manner.

In addition to the electrical benefits, the power module 21 described also entails advantages from the point of view of heat dissipation. The heat is in fact generated by the power devices 22, which are all coupled with the outside through high thermal-conductivity paths essentially transverse to the main faces 30a, 30b of the insulating body 30 and therefore along the shortest via. Furthermore, the structure of the power module 21 allows using components with a wide passage section in a direction perpendicular to the main faces 30a, 30b of the insulating body 30 and creating extensive heat-exchange surfaces towards the outside in accordance with the design preferences. Heat extraction is therefore allowed.

Since the first lead frame 23 and the second lead frame 25 are partially superimposed, the power module 21 has small dimensions with respect to the existing modules and may allow an area saving of up to 500.

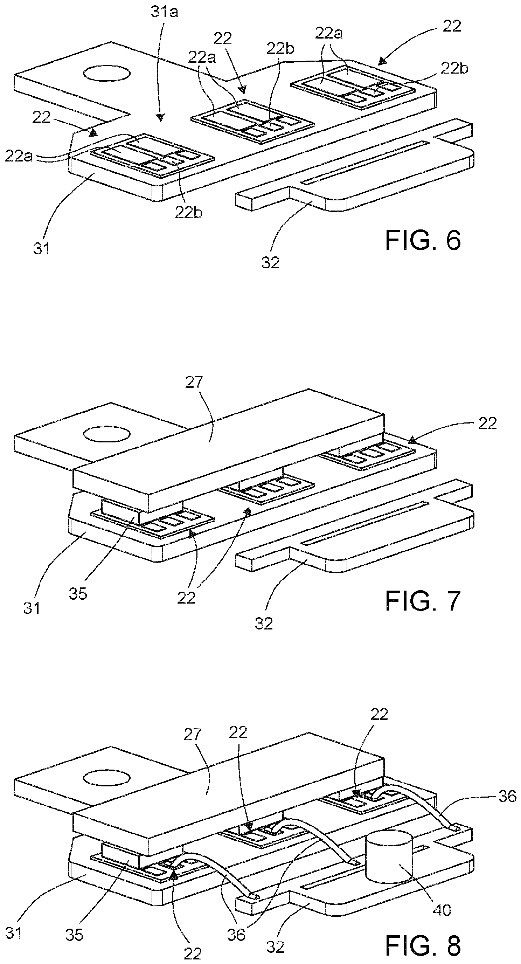

The power module 21 described may be obtained with a simplified manufacturing process, according to which the low-side 21a and the high-side 21b are preassembled and then joined together, as shown in Figures 6-12.

In particular, the power devices 22 of the low-side 21a are joined to the first power plate 31, for example by sintering (Figure 6). However, it is understood that, in this as in all subsequent steps of joining the components of the power module, any other coupling or die attach technique may be used in accordance with the design preferences. For example, it is possible to use any type of soldering or bonding and also mixed techniques, for example sintering for some components and soldering for other components of the same power module.

The conductive columns 35 and the first contact plate 27 are then joined to the source terminals 22a, again by sintering (Figure 7).

Then (Figure 8), the bonding wires 36 connecting the gate terminals 22b of the power devices 22 of the low-side 21a to the first control plate 32 are formed, and the first conductive pillar 40 is applied to the first control plate 32, conveniently still by sintering. The low-side 21a is thus completed.

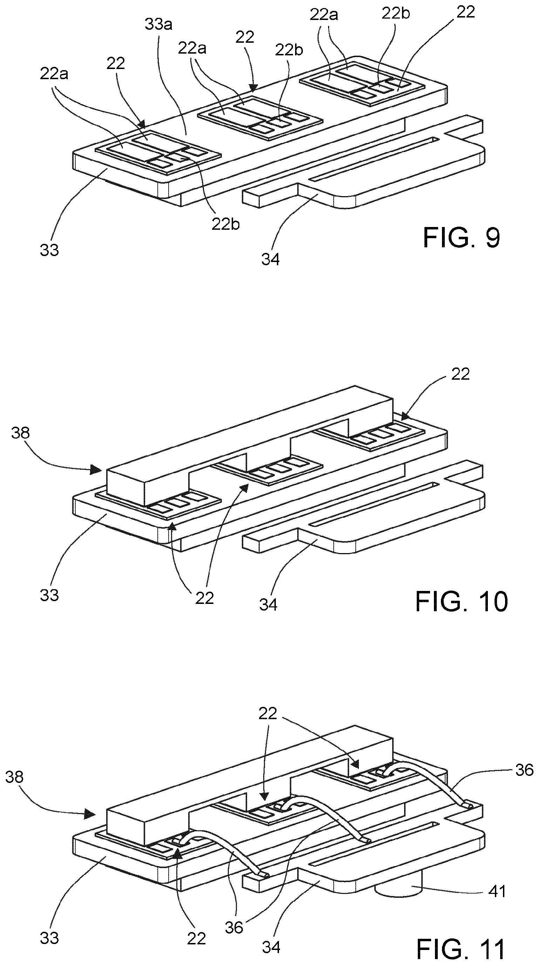

Similarly (Figure 9), the power devices 22 of the high-side 21b are joined to the second power plate 33 by sintering, then the conductive bridge 38 is joined to the source terminals 22a, again by sintering (Figure 10).

Then (Figure 11), the bonding wires 36 connecting the gate terminals 22b of the power devices 22 of the high-side 21b to the second control plate 34 are formed, and the second conductive pillar 41 is applied to the second control plate 34, again by sintering. The high-side 21b is thus also completed.

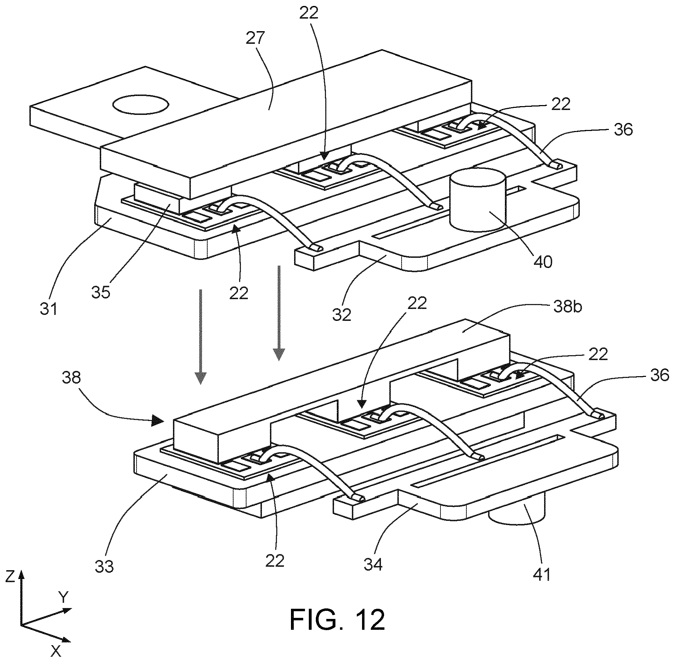

The first power plate 31 and the second power plate 33 are then superimposed and aligned and the first power plate is joined to the crosspiece 38b of the conductive bridge 38 by sintering (Figure 12).

The insulating body 30 is then formed by co-molding and the power module 21 of Figures 2-4 is obtained.

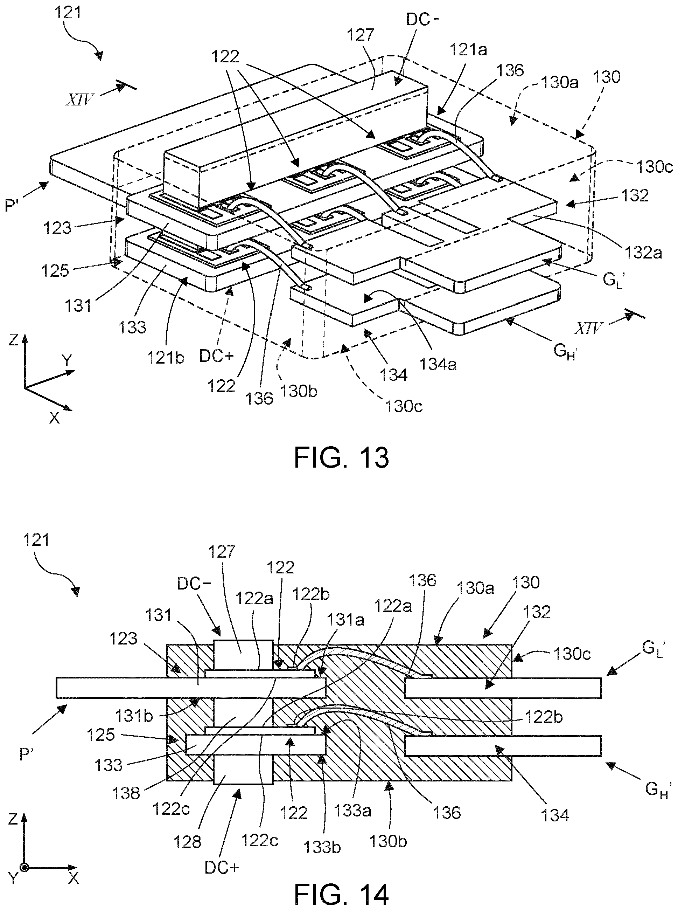

With reference to Figures 13 and 14, a power module 121 in accordance with a different embodiment of the invention comprises a plurality of power devices 122, a first connection structure or lead frame 123, accommodating a first group of power devices 122 which define a low-side 121a of the power module 121, a second connection structure or lead frame 125, accommodating a second group of power devices 122 which define a high-side 121b of the power module 121, a first contact plate 127, a second contact plate 128 and an insulating body 130 of a resin or other polymeric material, wherein the first lead frame 123 and the second lead frame 125 are at least partially embedded. The insulating body 130 has a parallelepiped shape and has a first main face 130a and a second main face 130b opposite to each other and lateral faces 130c opposite in pairs. The first contact plate 127 and the second contact plate 128 protrude respectively through the first main face 130a and the second main face 130b of the insulating body 130 remaining exposed to be accessible from the outside and respectively define a low-side supply terminal (DC-) and a high-side supply terminal (DC+) of the power module 121.

The first lead frame 123 comprises a first power plate 131 and a first control plate 132; the second lead frame 125 comprises a second power plate 133 and a second control plate 134. A portion of the first power plate 131 protrudes through one of the lateral faces 130c of the insulating body 130 and defines a phase terminal P' of the power module 121.

The power devices 122 of the low-side 121a are arranged on a first face 131a (plane and perpendicular to the Z axis) of the first power plate 131 and have respective source terminals 122a coupled, in this case directly coupled, to the first contact plate 127. The drain terminals 122c of the power devices 122 of the low-side 121a are joined to the first power plate 131 for example by sintering, while the related gate terminals 122b are connected to the first control plate 132 by respective bonding wires 136.

The power devices 122 of the high-side 121b are arranged on a first face 133a (plane and perpendicular to the Z axis) of the second power plate 133 oriented towards the first power plate 131. The source terminals 122a of the power devices 122 of the high-side 121b are coupled to each other and to the first power plate 131 through a conductive bridge 138. In one embodiment, the conductive bridge 138 may be defined by a conductive bar directly coupled to the source terminals 122a of the power devices 122 of the high-side 121b and to the power plate 131. In practice, the source terminals 122a, the first contact plate 127, the second contact plate 128 and the conductive bridge 138 are aligned along the Z axis. The first control plate 132 and the second control plate 134 are aligned, along the X axis, respectively with the first power plate 131 and the second power plate 133.

The drain terminals 122c of the power devices 122 of the high-side 121b are joined to the second power plate 133 for example by sintering, while the gate terminals 122b are connected to the second control plate 134 by respective bonding wires 136.

The second power plate 133 is coupled to the second contact plate 128 for connection to the outside. In particular, the second contact plate 128 extends from a second face 133b (plane and perpendicular to the Z axis) of the second power plate 133 opposite to the first face 133a.

Portions of the first control plate 132 and the second control plate 134 protrude through one of the lateral faces 130c in an opposite direction with respect to the first power plate 131 and respectively define a control terminal G_{L}' of the low-side 121a and a control terminal G_{H}' of the high-side 121b of the power module 121.

The first control plate 132 and the second control plate 134 are shaped so that the conductive paths respectively between the control terminal G_{L}' and the gate terminals 122b of the power devices 122 of the low-side 121a and between the control terminal G_{H}' and the gate terminals 122b of the power devices 122 of the high-side 121b are balanced as to the associated resistance, inductance and capacitance components. For example, the first control plate 132 and the second control plate 134 are provided with fingers 132a, 134a, which extend respectively from the control terminal G_{L}' and the control terminal G_{H}'. A respective bonding wire 136 is connected to each finger 132a, 134a and the width of the fingers 132a, 134a is selected as a function of the distance of the bonding wire 136 respectively from the control terminal G_{L}' and the control terminal G_{H}'.

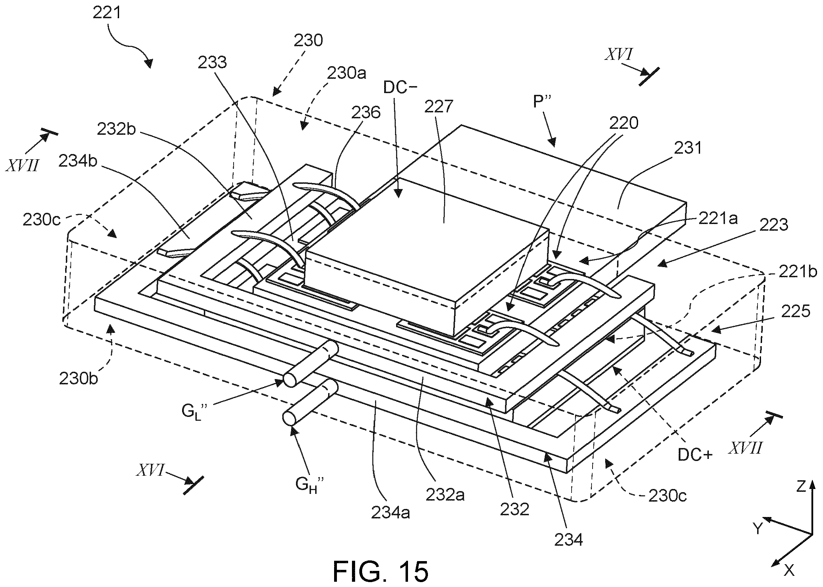

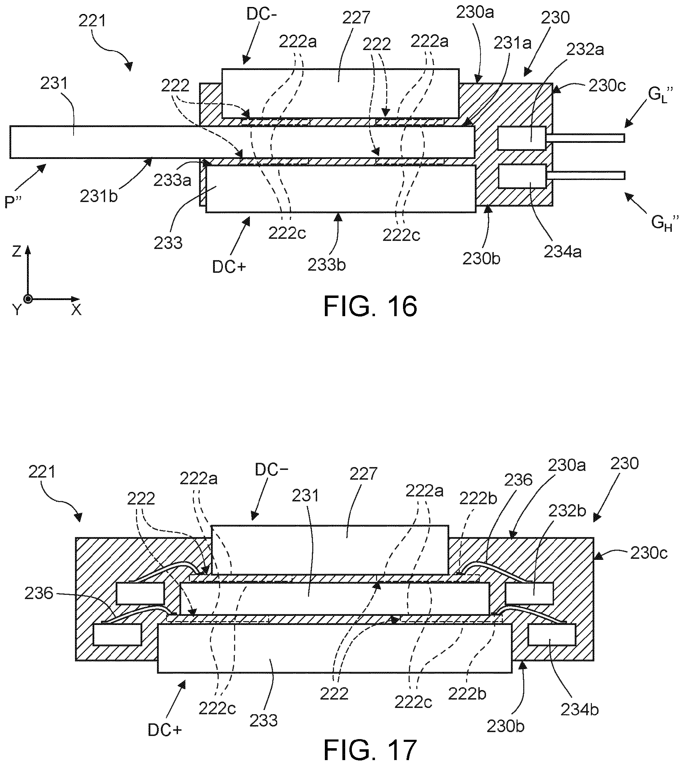

According to a further embodiment of the present invention, illustrated in Figures 15-17, a power module in accordance with an embodiment of the present invention is indicated as a whole by the number 221 and comprises a plurality of power devices 222, a first connection structure or lead frame 223, accommodating a first group of power devices 222 which define a low-side 221a of the power module 221, a second connection structure or lead frame 225, accommodating a second group of power devices 222 which define a high-side 221b of the power module 221, a first contact plate 227 and an insulating body 230, wherein the first lead frame 223 and the second lead frame 225 are at least partially embedded. The insulating body 230 has a parallelepiped shape and has a first main face 230a and a second main face 230b opposite to each other and lateral faces 230c opposite in pairs. The first contact plate 227 and a portion of the second lead frame 225, which functions as the second contact plate, protrude respectively through the first main face 230a and the second main face 230b of the insulating body 230 remaining exposed to be accessible from the outside and respectively define a low-side supply terminal (DC-) and a high-side supply terminal (DC+) of the power module 221.

The first lead frame 223 comprises a first power plate 231 and a first control plate 232; the second lead frame 225 comprises a second power plate 233 and a second control plate 234. The first power plate 231 and the second power plate 233 at least partly face each other. The first control plate 232 and the second control plate 234 are coplanar respectively with the first power plate 231 and the second power plate 233; in other words, the first control plate 232 and the second control plate 234 are aligned, along the X axis, respectively with the first power plate 231 and the second power plate 233.

The first power plate 231 accommodates the power devices 222 of the low-side 221a on a first face 231a, while a second face 231b of the first power plate 231 is oriented towards the second power plate 233. Each of the first and second face 231a, 231b of the first power plate 231 is a plane face perpendicular to the Z axis. Drain terminals 222c of the power devices 222 of the low-side 221a are joined to the first face 231a of the first power plate 231. Furthermore, a portion of the first power plate 231 protrudes through one of the lateral faces 230c of the insulating body 230 and defines a phase terminal P" of the power module 221.

The second power plate 233 has a first face 233a and a second face 233b opposite to each other, plane and perpendicular to the Z axis. The first face 233a of the second power plate 233 is oriented towards the first power plate 231 and accommodates the power devices 222 of the high-side 221b. Drain terminals 222c of the power devices 222 of the high-side 221b are joined to the first face 233a of the first power plate 233. A portion of the second power plate 233 protrudes through the second main face 230b of the insulating body 230 and defines the second contact plate of the power module 221.

In one embodiment, the first control plate 232 and the second control plate 234 are C-shaped and extend about the first power plate 231 and about the second power plate 233, respectively. Furthermore, connection elements of the first control plate 232 and the second control plate 234 protrude through one of the lateral faces 230c in an opposite direction with respect to the first power plate 231 and respectively define a control terminal G_{L}" of the low-side 221a and a control terminal G_{H}" of the high-side 221b of the power module 221.

The first control plate 232 has a back 232a and arms 232b which extend from the back 232a adjacent to respective sides of the first power plate 231. The power devices 222 of the low-side 221a are aligned in rows along the arms 232b and have the gate terminals 222b oriented towards the same arms 232b. Bonding wires 236 connect the gate terminals 222b of the power devices 222 of the low-side 221a to the respective adjacent arms 232b.

Similarly, the second control plate 234 has a back 234a and arms 234b which extend from the back 234a adjacent to respective sides of the second power plate 233. The power devices 222 of the high-side 221b are aligned in rows along the arms 234b and have the gate terminals 222b oriented towards the same arms 234b. Bonding wires 236 connect the gate terminals 222b of the power devices 222 of the high-side 221b to the respective adjacent arms 234b. In one embodiment, the back 234a of the second control plate 234 is longer than the back 232a of the first control plate 232 and therefore the distance between the arms 234b is greater than the distance between the arms 232a.

In the embodiment of Figures 15-17, the first contact plate 227 is coupled directly to the source terminals 222a of the power devices 222 of the low-side 221a. In particular, the contact plate 227 extends between the two rows of the power devices 222 of the low-side 221a and is superimposed on the source terminals 222a, having the same contact plate 227 directly joined thereto. The gate terminals 222b of the power devices 222 of the low-side 221a protrude laterally from the first contact plate 227.

The first power plate 231 is superimposed on and directly coupled to the source terminals 222a of the power devices 222 of the high-side 221b, in this case without interposing conductive bridges. The two rows of the power devices 222 of the high-side 221b are spaced from each other so that the related gate terminals 222b protrude laterally from the first power plate 231.

Finally, it is clear that modifications and variations may be made to what is described and illustrated herein without thereby departing from the scope of the present invention, as defined in the attached claims.

For example, the power devices may be organized on more than two levels, with more than two lead frames stacked on each other.

## Claims

1. A power module (21; 121; 221) comprising:
an insulating body (30; 130; 230) having a first main face (30a; 130a; 230a) and a second main face (30b; 130b; 230b);
a first contact plate (27; 127; 227) and a second contact plate (28; 128), protruding respectively through the first main face (30a; 130a; 230a) and through the second main face (30b; 130b; 230b) of the insulating body (30; 130; 230) and accessible from the outside of the power module (21; 121; 221);
a first power plate (31; 131; 231) and a second power plate (33; 133; 233), at least partially embedded in the insulating body (30; 130; 230), facing each other and having plane faces perpendicular to a first direction (Z);
a first group (21a; 121a; 221a) of power devices (22; 122; 222) accommodated on the first power plate (31; 131; 231) and coupled to the first contact plate (27; 127; 227);
a second group (21b; 121b; 221b) of power devices (22; 122; 222) accommodated on the second power plate (33; 133; 233) and coupled to the second contact plate (28; 128);
wherein the first contact plate (27; 127; 227), the second contact plate (28; 128), the first power plate (31; 131; 231) and the second power plate (33; 133; 233), are at least partly stacked along the first direction (Z).

2. The power module according to claim 1, wherein the power devices (22; 122; 222) of the first group (21a; 121a; 221a) are stacked with respective power devices (22; 122; 222) of the second group (21b; 121b; 221b) along the first direction (Z) .

3. The power module according to claim 1 or 2, wherein a portion of the first power plate (31; 131; 231) protrudes from the insulating body (30; 130; 230) and defines an external conduction terminal (P; P'; P").

4. The power module according to any of the preceding claims, comprising a first connection structure (35), connecting first conduction terminals (22a) of the power devices (22) of the first group (21a) to the first contact plate (27) and extending along the first direction (Z).

5. The power module according to claim 4, wherein the first connection structure (35) comprises conductive columns fixed to the first conduction terminals (22a) of the power devices (22) of the first group (21a) and to the first contact plate (27).

6. The power module according to any of claims 1 to 3, wherein first conduction terminals (22a) of the power devices (122; 222) of the first group (121a; 221a) are coupled directly to the first contact plate (127; 227).

7. The power module according to any of claims 4 to 6, wherein second conduction terminals (22c; 122c; 222c) of the power devices (22; 122; 222) of the first group (21a; 121a; 221a) are joined to a face (31a; 131a; 231a) of the first power plate (31; 131; 231).

8. The power module according to any of the preceding claims, comprising a second connection structure (38; 138) connecting first conduction terminals (22a; 122a) of the power devices (22; 122) of the second group (21b; 121b) to the first power plate (31; 131) and extending along the first direction (Z) .

9. The power module according to claim 8, wherein the second connection structure (38; 138) comprises a conductive bridge having struts (38a) fixed to the first conduction terminals (22a; 122a) of the power devices (22; 122) of the second group (21b; 121b) and to the first power plate (31; 131) .

10. The power module according to claim 8, wherein the first conduction terminals (222a) of the power devices (222) of the second group (221b) are directly coupled to the first power plate (31; 131).

11. The power module according to any of claims 8 to 10, wherein second conduction terminals (22c; 122c; 222c) of the power devices (22; 122; 222) of the second group (21b; 121b; 221b) are joined to a face (33a; 133a; 233a) of the second power plate (33; 133; 233).

12. The power module according to any of the preceding claims, wherein the second power plate (33; 133; 233) is joined to the second contact plate (28; 128).

13. The power module according to any of the preceding claims, comprising a first control plate (32; 132; 232) aligned with the first power plate (31; 131; 231) along a second direction (X) perpendicular to the first direction (Z) and connected to control terminals (22b; 122b; 222b) of the power devices (22; 122; 222) of the first group (21a; 121a; 221a) and a second control plate (34; 134; 234) aligned with the second power plate (33; 133; 233) along the second direction (X) and connected to control terminals (22b; 122b; 222b) of the power devices (22; 122; 222) of the second group (21b; 121b; 221b).

14. The power module according to claim 13, comprising a first conductive pillar (40), fixed to the first control plate (32) and protruding through the first main face (30a) of the insulating body (30), and a second conductive pillar (41), fixed to the second control plate (34) and protruding through the second main face (30b) of the insulating body (30), wherein protruding portions of the first conductive pillar (40) and the second conductive pillar (41) define, respectively, a first external control terminal (G_{L}) and a second external control terminal (G_{H}).

15. The power module according to claim 13, wherein portions of the first control plate (132; 232) and the second control plate (134; 234) protrude from the insulating body (130; 230) and respectively define a first external control terminal (G_{L}'; G_{L}") and a second external control terminal (G_{H}'; G_{H}").

16. A method for assembling a power module, comprising:
joining a first group (21a; 121a; 221a) of power devices (22; 122; 222) to a first power plate (31; 131; 231) having plane faces perpendicular to a first direction (Z);
stacking and joining a first contact plate (27; 127; 227) onto the power devices (22; 122; 222) of the first group (21a; 121a; 221a);
joining a second group (21b; 121b; 221b) of power devices (22; 122; 222) to a second power plate (33; 133; 233) having plane faces perpendicular to the first direction (Z), wherein the second power plate (33; 133; 233) is stacked and joined onto a second contact plate (28; 128) extending opposite to the power devices (22; 122; 222) of the second group (21b; 121b; 221b);
stacking, at least partly, along the first direction (Z) the first power plate (31; 131; 231) on the second power plate (33; 133; 233);
including the first power plate (31; 131; 231), the second power plate (33; 133; 233), the first group (21a; 121a; 221a) of power devices (22; 122; 222) and the second group (21b; 121b; 221b) of power devices (22; 122; 222) in an insulating body (30; 130; 230) having a first main face (30a; 130a; 230a) and a second main face (30b; 130b; 230b) opposite to the first main face (30a; 130a; 230a) along the first direction (Z), so that the first contact plate (27; 127; 227) and the second contact plate (28; 128) respectively protrude through the first main face (30a; 130a; 230a) and through the second main face (30b; 130b; 230b) of the insulating body (30; 130; 230).

17. The method according to claim 16, wherein stacking the first power plate (31; 131; 231) on the second power plate (33; 133; 233) comprises stacking the power devices (22; 122; 222) of the first group (21a; 121a; 221a) on respective power devices (22; 122; 222) of the second group (21b; 121b; 221b) along the first direction (Z).
